(19) **Europäisches Patentamt**

**European Patent Office**

**Office européen des brevets**

(11) **EP 1 127 626 A2**

(12) **EUROPÄISCHE PATENTANMELDUNG**

(43) Veröffentlichungstag:
**29.08.2001 Patentblatt 2001/35**

(51) Int Cl.⁷: $B06B\ 1/06$

(21) Anmeldenummer: **01101035.2**

(22) Anmeldetag: **18.01.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **21.02.2000 DE 10007857**
**31.05.2000 DE 10027013**

(71) Anmelder: **CeramTec AG Innovative Ceramic Engineering**
**73207 Plochingen (DE)**

(72) Erfinder:
• **Schreiner, Hans-Jürgen, Dr.**
**91233 Neunkirchen am Sand-Rollhofen (DE)**
• **Bindig, Reiner**
**95463 Bindlach (DE)**
• **Tzschentke, Konrad**
**91224 Pommelsbrunn (DE)**

(74) Vertreter: **Scherzberg, Andreas, Dr. et al**
**c/o DYNAMIT NOBEL AKTIENGESELLSCHAFT, Patentabteilung**
**53839 Troisdorf (DE)**

(54) **Verfahren zur Ladung bzw. Entladung von piezoelektrischen Bauelementen**

(57)      Die Erfindung betrifft ein Verfahren zur Ladung bzw. Entladung von piezoelektrischen Bauelementen (A) auf eine vorgegebene Spannung, bestehend aus einem Ladestromkreis und einem Entladestromkreis, wobei der Ladestromkreis aus einer Serienschaltung zumindest einer Spannungsquelle ($U_o$), eines Ladeschalters (L), eines Strombegrenzers und des Bauelements (A) besteht und der Entladestromkreis aus einer Serienschaltung zumindest des Bauelements (A), eines Entladeschalters (E) und eines weiteren Strombegrenzers besteht.

Zur Vereinfachung der elektronischen Schaltung ohne komplexe Regelung wird vorgeschlagen, daß der Lade- bzw. Entladevorgang über einen konstanten Strom ($I_L$, $I_E$) und einstellbaren Lade- bzw. Entladezeiten erfolgt.

Fig. 1

**Beschreibung**

Die Erfindung betrifft ein Verfahren und eine Vorrichtung zur Ladung bzw. Entladung von piezoelektrischen Bauelementen auf eine vorgegebene Spannung über eine elektronische Schaltung bestehend aus einem Ladestromkreis und einem Entladestromkreis, wobei der Ladestromkreis aus einer Serienschaltung zumindest einer Spannungsquelle $U_0$, eines Ladeschalters L, eines Strombegrenzers und des Bauelements besteht und der Entladestromkreis aus einer Serienschaltung zumindest des Bauelements, eines Entladeschalters und eines weiteren Strombegrenzers besteht

Die elektrische Ansteuerung bzw. das Laden und Entladen von keramischen Multilayeraktoren ist eine Grundvoraussetzung zu ihrem Betrieb, da die erzielte spätere Auslenkung des Aktors und ihr zeitlicher Verlauf durch sie bestimmt wird. Die Anforderungen an eine solche Ansteuerung sind vom jeweils gewünschten Betrieb abhängig. Zwei Betriebsarten sind zu unterscheiden: dynamisch mit Wiederholraten von 1 Hz bis zu ca. 100 Hz und Anstiegszeiten von 50 µs bis einigen ms und statischer Betrieb, bei dem die Betriebsspannung nur langsam variiert wird.

Eine dynamische Ansteuerung von Aktoren wird mit zwei unterschiedlichen Techniken erreicht:

1. Ansteuerung mittels Spannungsverstärker
Ein Spannungsverstärker wird mittels Signalquelle (Funktionsgenerator) angesprochen und erzeugt eine dazu proportionale Ausgangsspannung. Für Aktoranwendungen kommen aufgrund der hohen Kapazität nur Geräte, die hohe Pulsströme erzeugen können in Frage. Spannungsspitzen aufgrund von Störungen in der Ansteuerung führen zu einer Schädigung des Aktors, da diese sofort in einen hohen Spitzenstrom umgewandelt werden. Geräte dieser Art neigen außerdem zu hochfrequenten Schwingungen, die ebenfalls den angeschlossenen Aktor zerstören können.

2. Ansteuerung mittels gepulster Strompakete, z. B. nach DE 198 14 594 A1.
Es wird mittels geregelter Stromimpulse ein linearer Anstieg der Aktorspannung erzielt. Die Ladung bzw. Entladung wird vor Erreichen der Ladeendspannung beendet, daher muß auf diese extrapoliert werden. Dies macht eine sehr komplexe Regelung notwendig.

Der Erfindung liegt die Aufgabe zugrunde, ein Verfahren und eine Vorrichtung zur Ladung bzw. Entladung von piezoelektrischen Bauelementen nach dem Oberbegriff des Anspruchs 1 und 7 so weiterzubilden, daß eine einfache elektronische Schaltung ohne komplexe Regelung verwendet werden kann.

Erfindungsgemäß wird diese Aufgabe bezüglich des Verfahrens dadurch gelöst, der Lade- bzw. Entladevorgang über einen konstanten Strom $I_L$, $I_E$ und einstellbaren Lade- bzw. Entladezeiten erfolgt.

Der Lade- bzw. Entladevorgang erfolgt dabei durch Öffnen bzw. Schließen des Lade- und/oder Entladeschalters. Der Ladeschalter kann dabei auch über das Laden bis zur Endspannung geöffnet bleiben. In diesem Falle sollte auch der Entladeschalter geschlossen bleiben. Ebenso kann auch der Entladeschalter nach der vollständigen Entladung geöffnet bleiben.

Bevorzugt werden die beiden Schalter (Lade- und Entladeschalter) und damit das Laden und Entladen durch ein vorgegebenes Logik- oder Analogsignal einer Logikeinheit gesteuert, wobei sowohl der zeitliche Verlauf des Logik- oder Analogsignals, d. h. sowohl die Lade- bzw. Entladezeiten als auch die Größe des konstanten Lade- oder Entladestroms vorgegeben werden.

Erfindungsgemäß kann der Lade- bzw. Entladevorgang mittels der vorgegebenen Steuersignale der Logikeinheit beliebig unterbrochen oder begonnen werden.

Eine erfindungsgemäße Vorrichtung zum Laden und Entladen von piezoelektrischen Bauelementen nach dem Oberbegriff des Anspruchs 7 ist dadurch gekennzeichnet, daß die elektronische Schaltung eine Logikeinheit enthält, die die Ladung bzw. Entladung über die Stellung des Ladeschalters bzw. Entladeschalters steuert und der Lade- oder Entladestrom $I_L$, $I_E$ konstant ist.

In einer bevorzugten Ausführungsform ist die Größe des konstanten Lade- und Entladestroms in der elektrischen Schaltung fest vorgegeben.

Alternativ wird die Größe des Lade- und Entladestroms von der Logikeinheit gesteuert.

Zweckmäßigerweise ist die Spannungsquelle eine Gleichspannungsquelle mit parallel geschaltetem Pufferkondensator.

Bevorzugt ist das piezoelektrische Bauelement ein Multilayeraktor. Multilayeraktoren sind z. B. in der DE 196 48 545 A1 beschrieben.

Die vorliegende Erfindung beschreibt ein Verfahren und eine Vorrichtung zum Laden und Entladen eines piezoelektrischen Elementes, das vorzugsweise, aber nicht ausschließlich, dynamisch betrieben wird. Es kann sich dabei beispielsweise um piezoelektrische Multilayeraktoren handeln, nachfolgend auch Aktoren genannt. Piezoelektrische Aktoren erweisen sich bei allen Anwendungen von Vorteil, bei denen es auf schnelle Bewegungen mit großer Kraft und Wiederholrate ankommt.

Piezoelektrische Elemente sind kapazitive Lasten mit ausgeprägter Hysterese sowohl für die Dehnung als auch die Polarisation ($C/m^2$) in Abhängigkeit vom elektrischen Feld. Daher bietet es sich an, die Ansteuerung durch einen konstanten Strom durchzuführen. Dies gilt sowohl für den Lade- als auch den Entladefall. Die Ladeendspannung kann entweder durch die anliegende Gesamtspannung oder die Ladezeit bestimmt werden.

Nachfolgend wird die Erfindung anhand von Figuren näher erläutert:

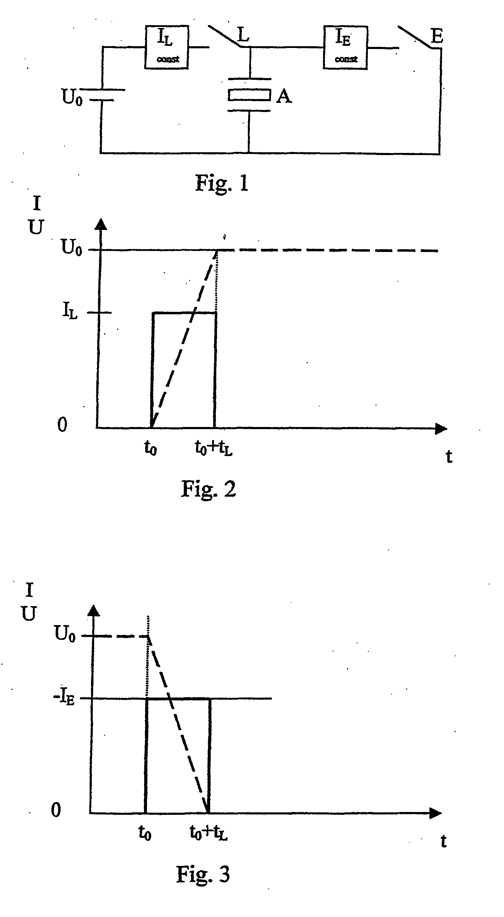

Eine Prinzipschaltung ist in Fig. 1 gezeigt. Gezeigt wird nur der Fall der Ladung, für den Entladefall gelten dieselben Betrachtungen. Das zu betreibende piezoelektrische Element ist mit A bezeichnet. Es wird über den einstellbaren Stromregler $I_L$ bei geschlossenem Schalter geladen und über den einstellbaren Stromregler $I_E$ bei geschlossenem Schalter L entladen. Während des Entladevorganges wiederum ist Schalter L geöffnet, während Schalter E offen ist. Auch wenn bis zur Ladeendspannung geladen wird, ergibt sich aufgrund der geringen ohmschen Widerstandsanteile eine nahezu lineare Ladekurve bis zur vollständigen Ladung, wie sie in Fig. 2 gezeigt ist. Die Ladezeit $t_L$ hängt dabei nur von der Kapazität C des piezoelektrischen Bauelementes, der Spannung $U_o$ und dem Ladestrom $I_L$ ab:

$$t_L = \frac{C \times U_o}{I_L}$$

Nach der vollständigen Ladung des Bauelementes geht der Strom $I_L$, auch bei geöffnetem Ladeschalter L auf 0 zurück, die Spannung $U_o$ liegt dann am Bauelement A an.

Wird die Ladung zu einer Zeit $t_1 < t_L$ beendet (Schalter L geöffnet), so ergibt sich die Ladeendspannung $U_e$ zu:

$$U_e = \frac{I_L \times t_1}{C}$$

Das bedeutet, daß die Ladecharakteristik durch Vorgabe des konstanten Ladestromes $I_L$ sowie der Ladeendspannug oder Ladezeit einstellbar ist. Dies ist in Fig. 2 veranschaulicht. Fig. 3 zeigt den Entladevorgang.

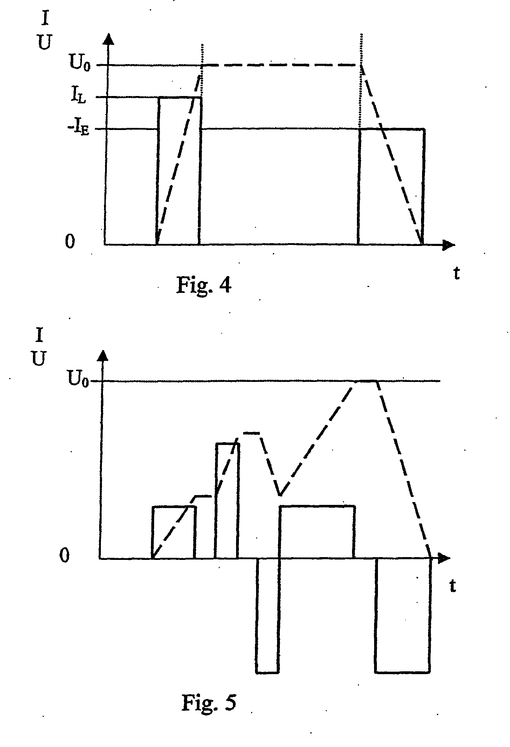

Wird jeweils bis zur vollständigen Ladung bzw. Entladung gewartet und beide Operationen nacheinander ausgeführt, so ergibt sich ein trapezförmiges Spannungssignal, dessen Flankensteilheit für die Ladung und Entladung getrennt eingestellt werden kann, wie Fig. 4 zeigt. Dieses Signal kann dann mit einer Frequenz bis zu mehreren 100 Hz wiederholt werden.

Aufgrund der Möglichkeit, die Ladung bzw. Entladung mittels Schalter L und E jederzeit zu starten bzw. zu unterbrechen, lassen sich nahezu beliebige Signalformen erzeugen. Ein Beispiel ist in Fig. 5 gegeben. Hier wird mehrmals geladen bzw. entladen.

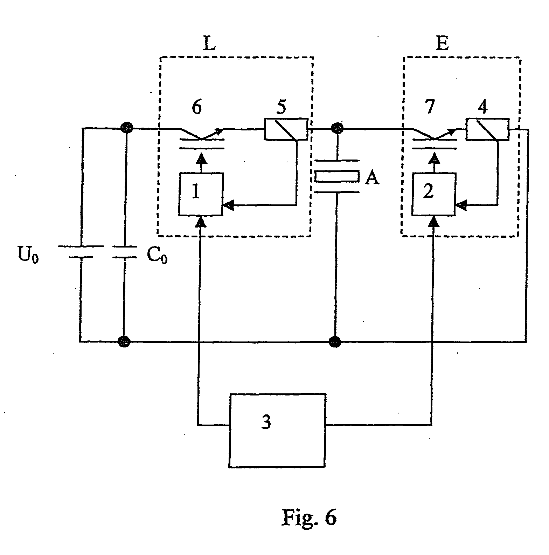

Im folgenden ist eine bevorzugte Vorrichtung beschrieben, die dem genannten Verfahren zur Ladung und Entladung eines piezoelektrischen Bauelementes folgt. In Fig. 6 ist das piezoelektrische Element mit A bezeichnet. Es liegt mit einem Pol am Minuspol der Spannungsversorgung $U_o$ (Masse). Der andere Anschluß ist einerseits über die Ladeschaltung mit dem Pluspol der Ladeschaltung und andererseits über die Entladeseite mit dem negativen Pol (Masse) der Spannungsversorgung $U_o$ verbunden. Mittels der einstellbaren Widerstände 4 bzw. 5 kann über die Steuereinheiten 1 bzw. 2 der Konstantstrom über einen Transistor 6, 7 geregelt werden. Die Logikeinheit 3 gibt über die Steuereinheiten 1 bzw. 2 die Lade- und Entladezeiten vor. Die Spannungsquelle $U_o$ ist eine Gleichspannungsquelle, der ein Pufferkondensator $C_o$ parallel geschaltet ist. Die Art der Gleichspannungsquelle ist so zu wählen, daß der gelieferte Dauerstrom zum Laden des Pufferkondensators während der Entladezeiten ausreicht. Der Ladeschalter L ist gestrichelt eingezeichnet und besteht im wesentlichen aus dem Transistor 6 mit zugehöriger Steuereinheit 1. Der Entladeschalter E besteht aus dem Transistor 7 und der Steuereinheit 2. Zum Betreiben der Steuereinheiten 1, 2 wird in den Widerständen 4, 5 eine Versorgungsspannung abgegriffen.

**Ladung bis zur Spannung $U_o$ und vollständiges Entladen**

Im Zustand "Laden" ist der Transistor 7 hochohmig, während der Transistor 6 den Ladestrom $I_L$ auf den voreingestellten Wert regelt. Wird die Endspannung erreicht, so sinkt der Ladestrom auf "0" A ab, die Versorgungsspannung liegt abzüglich der am Transistor abfallenden Spannung (ca. 4 V) an A an. Die Transistoren 6 und 7 bleiben in ihrem Zustand bis das Signal "Entladen" von der Logikeinheit 3 kommt. Im Zustand "Entladen" wird der Transistor 6 hochohmig und der Transistor 7 stellt den Entladestrom auf den voreingestellten Wert ein. Nach der vollständigen Entladung bleiben beide Transistoren in ihrem Zustand.

**Laden bis zu einer Endspannung < $U_o$**

Im Zustand "Laden" ist der Transistor 7 hochohmig, während der Transistor 6 den Ladestrom auf den voreingestellten Wert regelt. Durch die Logikeinheit 3 wird der Ladevorgang beendet, Transistor 6 wird hochohmig, Transistor 7 bleibt hochohmig. Entsprechendes gilt für die Entladung. Durch Kombination von mehreren Teilschritten kann eine Ladecharakteristik wie in Fig. 5 erreicht werden.

**Patentansprüche**

1. Verfahren zur Ladung bzw. Entladung von piezoelektrischen Bauelementen (A) auf eine vorgegebene Spannung über eine elektronische Schaltung, bestehend aus einem Ladestromkreis und einem Entladestromkreis, wobei der Ladestromkreis aus einer Serienschaltung zumindest einer Spannungsquelle ($U_o$), eines Ladeschalters (L), eines Strombegrenzers und des Bauelements (A) besteht und der Entladestromkreis aus einer Serienschaltung zumindest des Bauelements (A), eines Entladeschalters (E) und eines weiteren Strombegrenzers besteht, dadurch gekennzeichnet, daß der Lade- bzw. Entladevorgang über einen konstanten Strom ($I_L$, $I_E$) und einstellbaren Lade- bzw. Entladezeiten erfolgt.

2. Verfahren nach Anspruch 1, dadurch gekennzeichnet, daß der Lade- bzw. Entladevorgang durch Öffnen bzw. Schließen des Lade- (L) und/oder Entladeschalters (E) erfolgt.

3. Verfahren nach Anspruch 1 oder 2, dadurch gekennzeichnet, daß der Ladeschalter (L) auch über das Laden bis zur Endspannung geöffnet bleibt.

4. Verfahren nach einem der Ansprüche 1 bis 3, dadurch gekennzeichnet, daß der Entladeschalter (E) nach der vollständigen Entladung geöffnet bleibt.

5. Verfahren nach einem der vorhergehenden Ansprüche, dadurch gekennzeichnet, daß die Schalter (L, E) und damit das Laden bzw. Entladen durch ein vorgegebenes Logik- oder Analogsignal einer Logikeinheit (3) gesteuert werden, wobei sowohl der zeitliche Verlauf des Logik- oder Analogsignals, d. h. die Lade- bzw. Entladezeiten als auch die Größe des konstanten Lade- oder Entladestroms ($I_L$, $I_E$) vorgegeben werden.

6. Verfahren nach einem der vorhergehenden Ansprüche, dadurch gekennzeichnet, daß der Lade- bzw. Entladevorgang mittels der vorgegebenen Steuersignale der Logikeinheit (3) beliebig unterbrochen oder begonnen werden kann.

7. Vorrichtung zum Laden und Entladen von piezoelektrischen Bauelementen (A) auf eine vorgegebene Spannung über eine elektronische Schaltung bestehend aus einem Ladestromkreis und einem Entladestromkreis, wobei der Ladestromkreis aus einer Serienschaltung zumindest einer Spannungsquelle ($U_o$), eines Ladeschalters (L), eines Strombegrenzers und des Bauelements (A) besteht und der Entladestromkreis aus einer Serienschaltung zumindest des Bauelements (A), eines Entladeschalters (E) und eines weiteren Strombegrenzers besteht, insbesondere nach einem der Ansprüche 1 bis 6, dadurch gekennzeichnet, daß die elektronische Schaltung eine Logikeinheit (3) enthält, die die Ladung bzw. Entladung über die Stellung des Ladeschalters (L) bzw. Entladeschalters (E) steuert und der Lade- oder Entladestrom ($I_L$, $I_E$) konstant ist.

8. Vorrichtung nach Anspruch 7, dadurch gekennzeichnet, daß die Größe des konstanten Ladestroms ($I_L$) und Entladestroms ($I_E$) in der elektronischen Schaltung einstellbar fest vorgegeben ist.

9. Vorrichtung nach Anspruch 7, dadurch gekennzeichnet, daß die Größe des konstanten Ladestroms ($I_L$) und Entladestroms ($I_E$) von der Logikeinheit (3) gesteuert ist.

10. Vorrichtung nach einem der Ansprüche 7 bis 9, dadurch gekennzeichnet, daß die Spannungsquelle ($U_o$) eine Gleichspannungsquelle mit parallel geschaltetem Pufferkondensator ($C_o$) ist.

11. Vorrichtung nach einem der Ansprüche 7 bis 10, dadurch gekennzeichnet, daß das piezoelektrische Bauelement (A) ein Multilayeraktor ist.

Fig. 1

Fig. 2

Fig. 3

Fig. 4

Fig. 5

Fig. 6